# EUROPÄISCHE PATENTSCHRIFT

(11) **EP 0 610 709 B1**
(45) Veröffentlichungstag und Bekanntmachung des Hinweises auf die Patenterteilung: **10.06.1998**
(21) Anmeldenummer: 94100990.4
(22) Anmeldetag: 24.01.1994
(51) Int. Cl.: H01L 21/98, H01L 25/065, H01L 23/48

(54) **Verfahren zur Herstellung einer dreidimensionalen Schaltungsanordnung**
Process of manufacturing tri-dimensional circuit devices
Procédé pour fabriquer des dispositifs à circuits tridimensionnels

(30) Priorität: 11.02.1993 DE 4304119
(43) Veröffentlichungstag der Anmeldung: 17.08.1994
(73) Patentinhaber: SIEMENS AKTIENGESELLSCHAFT, 80333 München (DE)
(72) Erfinder: Hubner, Holger, Dr, D-85598 Baldham (DE)

(56) Entgegenhaltungen:
- EP-A- 0 238 089
- WO-A-91/11833
- WO-A-92/06491
- US-A- 4 893 174
- US-A- 4 897 708
- US-A- 5 170 930

## Beschreibung

Es werden zunehmend Halbleiterschaltungen entworfen, in denen integrierte Schaltungen verschiedener Technologien kombiniert werden. So werden z. B. CMOS-Speicher mit bipolaren Prozessoren oder Sensorbausteine mit Logikbausteinen kombiniert. Dabei werden die integrierten Schaltungen üblicherweise auf Leiterplatten nebeneinander angeordnet. Die Kontaktierung untereinander erfolgt über Metallbahnen.

Künftig sollen solche unterschiedlichen integrierten Schaltungen in einem Chipgehäuse zusammengefaßt werden, um eine Erhöhung der Packungsdichte und eine Verkürzung der Verbindungswege zu erzielen. Dabei werden die integrierten Schaltungen enthaltenden Substrate, die aus unterschiedlichen Substratmaterialien bestehen können und/oder in unterschiedlichen Technologien gefertigt sein können, jeweils bis auf wenige 10 µm dünn geschliffen und als Stapel, auch Stack genannt, angeordnet. In senkrechter Richtung müssen durch die Substrate hindurch Kontakte gebildet werden. Ein solcher Bauelementstapel erscheint von außen betrachtet als neuer Halbleiterbaustein. Er kann in einem Standardgehause mit reduzierter Anschlußzahl realisiert werden, obgleich er eine gesteigerte Funktionalität aufweist.

Aus Three-Dimensional ICs Project (Fiscal 1981 - 1990) Research and Development Association for Future Electron. Dev., FED, Tokyo, 1991, Kap. 2.1 ist ein Verfahren bekannt, mit dem vertikale Kontakte zwischen in einem Stapel übereinander angeordneten Substraten realisiert werden können. In dem bekannten Verfahren werden Kontakte zwischen einem oberen Substrat und einem unteren Substrat, die unmittelbar benachbart zueinander im Stapel übereinander angeordnet sind, dadurch erzeugt, daß auf der Oberseite des unteren Substrats Wolframstifte mit einem Querschnitt von etwa 3 x 3 µm² gebildet werden. Diese Wolframstifte stehen 1 bis 2 µm über die Oberseite des unteren Substrates heraus. An einer korrespondierenden Stelle der Unterseite des oberen Substrats werden großflächige Vertiefungen, die Abmessungen von etwa 20 x 20 µm² aufweisen, erzeugt, die mit einer Au/In-Legierung gefüllt werden. In diese gefüllten Vertiefungen tauchen die Wolframstifte beim Übereinanderstapeln des oberen Substrats und des unteren Substrats ein. Sie werden bei 300 bis 400 °C verlötet. Zum Ausgleich von Oberflächentopographien und zu einer zusätzlichen mechanischen Verbindung zwischen dem oberen Substrat und dem unteren Substrat wird auf die Oberseite des unteren Substrats sowie auf die Unterseite des oberen Substrats je eine Polyimidschicht als Kleber aufgebracht.

Zur Herstellung der Vertiefungen auf der Unterseite der oberen Substrat wird auf die Oberseite der oberen Substrate eine stabilisierende Trägerplatte geklebt. Anschließend wird das obere Substrat an der Unterseite angeschliffen. An der Unterseite wird anschließend eine zusätzliche Verdrahtungsebene erzeugt, die mit einer Metallisierungsebene der Schaltung in Verbindung steht. Die zusätzliche Verdrahtungsebene wird mit einer Polymidschicht bedeckt, in der die Vertiefungen erzeugt werden, die mit Au/In aufgefüllt werden. Die Vertiefungen reichen dabei auf die zusätzliche Verdrahtungsebene. Diese Prozeßschritte führen zu beträchtlichen Spannungen, die das dünne Substrat verziehen oder sogar brechen lassen können, wenn die Trägerplatte den Anforderungen nicht gewachsen ist.

Auf der Oberseite der unteren Substrate werden die Wolframstifte jeweils bei Temperaturen um 400 °C - 500 °C abgeschieden. Beim Abkühlen der Stifte wird das untere Substrat unter große, punktuell angreifende Spannungen versetzt. Bei empfindlichen Substratmaterialien wie z. B. GaAs oder InP kann es dabei zu Spannungsrissen kommen.

Bei der Verlötung des oberen Substrats mit dem unteren Substrat kommt es zu seitlichen Verschiebungen zwischen den Vertiefungen und den Wolframstiften, da die beiden Substrate ungleiche Ausdehnungskoeffizienten haben. Damit einander zugeordnete Wolframstifte und Vertiefungen trotz dieser Verschiebungen aufeinandertreffen, müssen die Justiertoleranzen und damit die Dimensionen der Vertiefungen entsprechend vergrößert werden. Beim Abkühlen nach dem Verlöten führen diese Verschiebungen dazu, daß auf die Wolframstifte starke Querkräfte ausgeübt werden, die zum Abscheren der Kontakte führen können.

Um den mechanischen Streß auf die Substrate auf ein erträgliches Maß zu reduzieren, dürfen die Wolframstifte nicht zu dicht angeordnet werden und nicht zu tief in das Substratmaterial hineingeführt werden. Daher tragen die Wolframstifte zur Abführung der Verlustwärme aus den Schaltungen und Bauelementen in den Substraten kaum bei.

Zur Bildung komplexer Bauelementestapel werden mehr als 2 Substrate aufeinandergelötet. Ein Auslösen der Kontakte bei der Verlötung weiterer Substrate kann in dem bekannten Verfahren nur dadurch vermieden werden, daß von Ebene zu Ebene Au/In-Legierungen mit sinkender Schmelztemperatur verwendet werden. Die wiederholte Erwärmung einer Legierung bis kurz unter den Schmelzpunkt führt jedoch zu einer Änderung der Kristallstruktur und zu einer Degradation der Kontakte.

Aus US-A-4 897 708 ist eine Halbleiterscheibenanordnung bekannt, in der eine Vielzahl Halbleiterscheiben übereinander angeordnet sind und untereinander durch Polyimid verbunden und isoliert sind. Durchgehende Kontaktlöcher zur Verbindung der Scheiben werden mit elektrisch leitfähigem flüssigem Material, insbesondere Quecksilber, aufgefüllt. Die durchgehenden Löcher werden oben und unten durch interne Anschlußflächen verschlossen.

Der Erfindung liegt das Problem zugrunde, ein Verfahren zur Herstellung einer dreidimensionalen Schaltungsanordnung anzugeben, bei dem die Nachteile des bekannten Verfahrens vermieden werden.

Dieses Problem wird erfindungsgemäß gelöst durch ein Verfahren nach Anspruch 1. Weitere Ausgestaltungen der Erfindung gehen aus den übrigen Ansprüchen hervor.

Der Begriff "Substrat" wird sowohl für Substratscheiben, die insbesondere aus Halbleitermaterial bestehen und mikroelektronische Schaltungsstrukturen und/oder optoelektronische Komponenten und/oder Sensorkomponenten umfassen, als auch für vereinzelte Bauelemente, optoelektronische Komponenten, Sensorelemente oder ähnliches verwendet.

In dem erfindungsgemäßen Verfahren wird sowohl in oberen Substraten auf der Unterseite als auch in diesen benachbarten unteren Substraten auf der Oberseite jeweils mindestens eine Vertiefung erzeugt, die im jeweiligen Substrat bis auf eine Metallisierungsebene reicht und deren Seitenwände mit einer Isolation versehen werden. Die Vertiefungen werden mit einem Gemisch aus zwei Metallkomponenten gefüllt, von denen bei der Verarbeitungstemperatur die eine flüssig und die andere fest ist und von denen sich die feste Komponente in der flüssigen Komponente löst, was zur Aushärtung des Gemisches führt. Bei Überschreitung der Solidus-Kurve im Phasendiagramm hat sich das Gemisch vollständig verfestigt. Das obere Substrat wird auf das untere Substrat so gestapelt, daß die Vertiefungen im oberen Substrat auf zugeordnete Vertiefungen im unteren Substrat treffen. Durch Aushärten des Gemisches wird eine feste Verbindung zwischen den benachbarten Substraten gebildet, die elektrisch leitend ist und dadurch einen Kontakt zwischen den Metallisierungsebenen in den benachbarten Substraten darstellt.

Für ein solches Gemisch, bei dem die flüssige Komponente aus Quecksilber besteht, wird im deutschen Sprachgebrauch vielfach der Begriff Amalgam verwendet. In C.A. Mac Kay, Proc. of the techn. Conf., 9th Annual Int. Electronics Packaging Conf., IEPS, San Diego, CA, USA, 11. - 13. Sept. 1989, S. 1244 - 1259 wird ein solches Gemisch auch dann als Amalgam bezeichent, wenn die flüssige Komponente beliebig mit den obengenannten Eigenschaften ist. In diesem Sinne wird der Begriff Amalgam im folgenden verwendet. Erfindungsgemäß ist die flüssige Komponente dabei nicht auf Quecksilber beschränkt. Insbesondere besteht die flüssige Komponente in dem erfindungsgemäßen Verfahren aus Quecksilber (Hg), Galium (Ga), Indium (In), Legierungen aus Ga/Sn, Ga/In oder Ga/In/Sn oder anderen Kombinationen mit Quecksilber, Cadmium und/oder Wismut. Die feste Komponente besteht in dem erfindungsgemäßen Verfahren insbesondere aus Antimon, Kobalt, Kupfer, Chrom, Germanium, Gold, Eisen, Nickel, Magensium, Mangan, Platin, Palladium, Silber oder Vanadium.

Durch Wahl der Komponenten läßt sich sowohl die Verarbeitungstemperatur als auch der Schmelzpunkt des ausgehärteten Amalgams einstellen. Verarbeitungstemperaturen unter 100 °C treten auf, wenn die flüssige Komponente z. B. aus Ga, Hg, In oder einer Legierung mit entsprechend niedrigem Schmelzpunkt, wie z. B. In/Sn, Ga/Sn oder Ga/In gebildet wird. Einen Schmelzpunkt über 500 °C hat ausgehärtetes Amalgam in den Systemen Ga/Ni, Hg/Al und Ga/Cu.

Aus C.A. MacKay, Proc. of the techn. Conf., 9th Annual Int. Electronics Packaging Conf., IEPS, San Diego, CA, USA, 11. - 13. Sept. 1989, S. 1244 - 1259 ist bekannt, Amalgame zum Bonden von Materialien mit deutlich unterschiedlichen thermischen Ausdehnungskoeffizienten oder von temperaturempfindlichen Komponenten zu verwenden. Dabei werden als Anwendungen jedoch nur makroskopische Anwendungen, wie z. B. das Bonden einer Solarzelle auf einem Träger oder das Aufbringen einer Wärmesenke, wobei zwei Platten ganzflächig verbunden werden, oder das Auffüllen von Durchgangslöchern in Keramiksubstraten, über die Metallbahnen auf Vorder- und Rückseite einer einzelnen Scheibe verbunden werden, beschrieben.

Die Verwendung von Amalgamen zur Verbindung und Durchkontaktierung von Substraten, die insbesondere mikroelektronische Schaltungen oder optoelektronische Komponenten umfassen, stellt dagegen einen Eingriff in das einzelne Bauelement dar. Dabei müssen Vertiefungen, die in der Größe der Strukturen des Bauelementes sind und die auf eine Metallisierungsebene des Bauelementes reichen, realisiert und aufgefüllt werden. Der genannten Literaturstelle ist zu entnehmen, daß zur Vergrößerung der Zeit zum Aushärten des Amalgams die feste Komponente ein Pulver mit einer Pulverteilchengröße von etwa 45 µm sein sollte, damit diese Zeit zur Verarbeitung ausreicht. Zur erfindungsgemäßen Verbindung und Durchkontaktierung von Substraten müssen Vertiefungen mit Durchmessern unter 10 µm, speziell 1 bis 3 µm, gefüllt werden. Eine Pulverteilchengröße von 45 µm ist dafür ungeeignet.

Es ist besonders vorteilhaft, die Vertiefungen, die Seitenwandisolationen und ggf. die Hilfsschicht zur Förderung der Benetzung an einer Substratscheibe vor der Vereinzelung der Substratscheibe in eine Vielzahl von Bauelementen vorzunehmen. Auf diese Weise brauchen die Bearbeitungsschritte jeweils nur einmal für die gesamte Substratscheibe vorgenommen werden. Zum Aufbau der dreidimensionalen Schaltungsanordnung ist es vorteilhaft, als oberes Substrat vereinzelte Bauelemente zu verwenden, die auf die entsprechende Stelle einer Substratscheibe, die als unteres Substrat verwendet wird, angeordnet und befestigt werden. Dadurch ist es möglich, nur funktionierende Bauelemente auf funktionierende Bauelemente der unteren Substratscheibe anzuordnen. Die Ausbeute des Verfahrens wird auf diese Weise drastisch erhöht, da nicht funktionierende Bauelemente nicht verwendet werden.

Nach dem Anordnen und Befestigen eines ersten Bauelements an der Oberfläche einer ersten Substratscheibe wird die erste Substratscheibe entsprechend der Form der Bauelemente vereinzelt, so daß Bauelementestapel entstehen. Diese können nun ihrerseits als vereinzelte Bauelemente auf einer weiteren Substratscheibe angeordnet und befestigt werden.

Substratscheiben, die als eine mittlere Ebene verwendet werden, d. h. die in aufeinanderfolgenden Verfahrensschritten sowohl als unteres als auch als oberes Substrat verwendet werden, werden auf gegenüberliegenden Seiten mit Vertiefungen versehen. Dabei wird zunächst diejenige Seite bearbeitet, an der die Schaltungsstrukturen und Bauelemente angeordnet sind. Es werden die Vertiefungen erzeugt, mit Seitenwandisolationen versehen, ggf. mit einer Hilfsschicht versehen und mit Amalgam gefüllt. Nach dem Aushärten des Amalgams wird auf diese Seite der Substratscheibe ein Träger aufgeklebt. Anschließend wird auf der dem Träger abgewandten Seite Substratmaterial abgetragen. Dieses erfolgt z. B. durch Dünnschleifen oder Spinnätzen. Das verbleibende Substratmaterial beträgt einige 10 µm Dicke. Dann werden in der dem Träger abgewandten Seite Vertiefungen erzeugt und mit einer Seitenwandisolation und ggf. einer Hilfsschicht versehen. Anschließend wird die Substratscheibe so gedreht, daß der Träger nach unten weist. Die Vertiefungen an der dem Träger abgewandten Seite werden mit Amalgam gefüllt und es werden die oder das Bauelement an der Oberseite der als unteres Substrat verwendeten Substratscheibe angeordnet. Nach dem Aushärten des Amalgams werden die Bauelementestapel vereinzelt.

Das Amalgam wird z. B. aus den Bestandteilen flüssiges Gallium und Kupferpulver oder flüssiges Gallium und Nickelpulver hergestellt. Es ist vorteilhaft, dabei Kupfer- oder Nickelpulver zu verwenden, in dem die einzelnen Pulverteilchen an der Oberfläche mit einer porösen Oxidschicht versehen sind. Diese poröse Oxidschicht verzögert den Lösungsprozeß des Pulvers im flüssigen Metall und führt auch bei feinen Pulvern mit Teilchendurchmessern von 1 bis 2 µm zu einer verlängerten Verarbeitungszeit.

Eine weitere Möglichkeit der Verlängerung der Verarbeitungszeit besteht darin, die feste Metallkomponente als dünne Schicht auf die Oberfläche der Vertiefungen aufzubringen. Die Vertiefungen werden anschließend mit der flüssigen Metallkomponente aufgefüllt. Die Durchmischung und Lösung der festen Metallkomponente mit der flüssigen Metallkomponente erfolgt in diesem Fall erst in der Vertiefung.

Es ist vorteilhaft, das flüssige Metall zu dotieren, da in diesem Fall das ausgehärtete Amalgam plastischer wird. Wird Gallium als flüssiges Metall verwendet, eignet sich Bor oder Wolfram als Dotierstoff.

Es ist vorteilhaft, die Vertiefungen mit dünnflüssigem Amalgam zu füllen und überschüssiges Amalgam abzuschütteln, um Kurzschlüsse zwischen Amalgamkontakten einer Ebene zu vermeiden. Das Abschütteln erfolgt z. B. durch eine taumelnde Rotationsbewegung. Die Taumelbewegung ist notwendig, damit auch im Bereich des Mittelpunkts einer Substratscheibe hinreichend große Fliehkräfte wirken. Eine andere Möglichkeit besteht in der Anlegung eines magnetischen Wechselfeldes. Dazu werden z. B. oberhalb und unterhalb der Substratscheibe zwei Magnetwicklungspakete wie bei einem Drehstromlinearmotor angeordnet. In deren Feld werden überschüssige Metallanteile aufgrund der induzierten Wirbelstromfelder zum Rand der Substratscheibe hin beschleunigt.

Es ist besonders vorteilhaft, Amalgame zu verwenden, die bei einer der Betriebstemperatur der Schaltungsanordnung entsprechenden Temperatur aushärten. Dadurch wird erzielt, daß die Verbindungen aus Amalgam im Betrieb der Schaltung kräftefrei bleiben. Ein weiterer Vorteil besteht darin, daß der Schmelzpunkt dieser Amalgame oberhalb der Aushärtetemperatur liegt. Damit können in einer Vielzahl aufeinanderfolgender Prozeßschritt praktisch beliebig viele Substrate miteinander verbunden werden, ohne daß zuvor realisierte Verbindungen dabei durch Aufweichen oder Auskristallisieren verändert werden.

Ein weiterer Vorteil bei der Verwendung flüssigem Amalgams zur Auffüllung der Vertiefungen in dem unteren Substrat besteht darin, daß bei Anordnen des oberen Substrats auf das untere Substrat durch die Oberflächenspannung des flüssigen Amalgams eine Feinjustierung der beiden Substrate zueinander erfolgt.

Zur Planarisierung der Oberflächen und zu einer zusätzlichen mechanischen Fixierung ist es vorteilhaft, auf aneinandergrenzende Flächen benachbarter Substrate jeweils eine Polyimidschicht aufzubringen. Durch eine Behandlung bei leicht erhöhter Temperatur schmelzen diese Polyimidschichten an und verbinden sich miteinander.

Da das Temperaturbudget in dem erfindungsgemäßen Verfahren mechanische Spannung in der Schaltungsanordnung vermeidet, kann der Querschnitt der als Kontakt verwendeten Amalgamverbindungen entsprechend den Anforderungen der Schaltung gewählt werden. Es ist z. B. möglich, den Querschnitt der Kontakte so groß zu wählen, daß sich Versorgungsströme über einen einzigen Kontakt führen lassen.

Darüberhinaus ist es möglich, zusätzlich weitere Vertiefungen in den Substraten vorzusehen, die nicht zur Kontaktierung dienen. Diese mit Amalgam gefüllten Vertiefungen erleichtern die Wärmeabfuhr aus der stapelförmigen Schaltungsanordnung in senkrechter Richtung.

Zur Wärmeableitung liegt es weiterhin im Rahmen der Erfindung, zwischen benachbarten Substraten Polyimidschichten vorzusehen, in denen parallel zur Oberfläche der Substrate verlaufende Gräben, die mit Amalgam gefüllt werden, erzeugt werden. Diese in lateraler Richtung verlaufenden Amalgambahnen fuhren Verlustwärme zur Peripherie des Stapels ab. Die Abfuhr der Verlustwärme aus einer Schaltungsanordnung gewinnt mit zunehmender Packungsdichte an Bedeutung.

Weitere Ausgestaltungen der Erfindung gehen aus den Unteransprüchen hervor.

Im folgenden wird die Erfindung anhand von Ausführungsbeispielen und der Figuren näher erläutert.
- Fig. 1: zeigt einen Ausschnitt aus einem Querschnitt durch ein Substrat, in dem eine bis auf eine Metallisierungsebene reichende Vertiefung erzeugt wurde, deren Seitenwande mit einer Isolation und mit einer Hilfsschicht versehen sind.
- Fig. 2: zeigt das Substrat nach der Auffüllung der Vertiefung mit Amalgam.
- Fig. 3: zeigt das Zusammenfügen eines unteren Substrats und eines oberen Substrats.
- Fig. 4: zeigt einen Ausschnitt aus einer dreidimensionalen Schaltungsanordnung, in der das untere und das obere Substrat über eine ausgehärtete Amalgamverbindung verbunden sind.
- Fig. 5: zeigt eine Substratscheibe, die eine Vielzahl von Bauelementen umfaßt.
- Fig. 6: zeigt ein vereinzeltes Bauelement.
- Fig. 7: zeigt eine Substratscheibe, an deren Oberfläche vereinzelte Bauelemente angeordnet und mit Amalgam verbunden sind.
- Fig. 8: zeigt einen vereinzelten Bauelementstapel.
- Fig. 9: zeigt eine Explosionszeichnung von zwei Substraten, die über mit Amalgam gefüllte Vertiefungen miteinander verbunden sind und zwischen denen eine Polyimidschicht mit mit Amalgam gefüllten Gräben zur lateralen Wärmeabfuhr angeordnet ist.

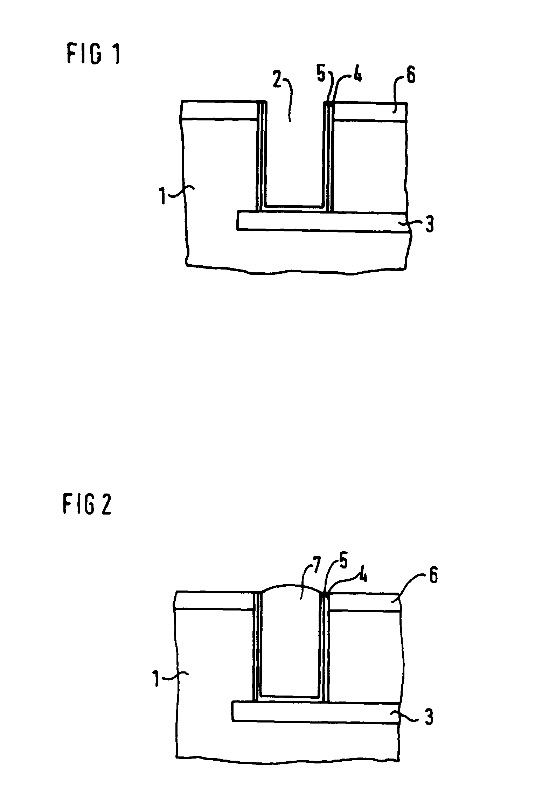

Auf die Oberfläche eines Substrats 1 wird ganzflächig eine Polyimidschicht 6 aufgebracht (s. Fig. 1). Das Substrat 1 ist z. B. eine Halbleiterscheibe aus einkristallinem Silizium oder einem III-V-Halbleiter. Das Substrat 1 umfaßt Schaltungsstrukturen, die Bestandteil einer mikroelektronischen Schaltung oder einer optoelektronischen Komponente oder einer Sensorkomponente sind. Die Schaltungsstrukturen, die im einzelnen nicht dargestellt sind, umfassen mindestens eine Metallisierungsebene 3.

Auf die Polyimidschicht 6 wird eine Fotolackmaske (nicht dargestellt) aufgebracht. Die Fotolackmaske wird bei einer anisotropen Ätzung, z. B. durch Plasmaätzung, zur Erzeugung einer Vertiefung 2 als Ätzmaske verwendet. Die Vertiefung 3 reicht bis auf die Metallisierungsebene 3. Innerhalb der Vertiefung 2 wird die Oberfläche der Metallisierung 3 vollständig freigelegt.

Es wird ganzflächig eine isolierende Schicht abgeschieden, die in einem anisotropen Ätzschritt rückgeätzt wird. Dabei entsteht eine Isolation 4 (s. Fig. 1), die die Seitenwand der Vertiefung 2 vollständig bedeckt. Die Isolation 4 besteht z. B. aus SiO₂. Bei dem anisotropen Rückätzen wird die isolierende Schicht an der Oberfläche der Metallisierungsebene 3 innerhalb der Vertiefung 2 entfernt, so daß über die Vertiefung 2 ein Kontakt zur Metallisierungsebene 3 hergestellt werden kann.

Anschließend wird eine Hilfsschicht 5 auf der Isolation 4 und dem Boden der Vertiefung 2 erzeugt. Die Hilfsschicht 5 besteht aus einem elektrisch leitenden Material, das die Benetzung der Oberfläche der Vertiefung 2 mit Amalgam erleichtert. Die Hilfsschicht 5 darf außerhalb der Vertiefung 2 nicht vorhanden sein, da sie zu einem elektrischen Kurzschluß zwischen benachbarten Vertiefungen führen wurde. Die Hilfsschicht 5 wird z. B. durch Abscheiden einer Schicht und anschließendes anisotropes Rückätzen hergestellt. Die Hilfsschicht 5 wird z. B. aus Titan gebildet. Bei Verwendung eines Amalgams mit einer flüssigen Metallkomponente, die die Oberfläche der Isolation 4 gut benetzt, wie dieses z. B. für flüssiges Gallium und SiO₂ als Isolation 4 der Fall ist, kann auf die Hilfsschicht 5 verzichtet werden.

Die Vertiefung 2 wird mit einem Amalgam 7 gefüllt (s. Fig. 2). Beim Aushärten des Amalgams 7 quillt dieses, so daß es leicht über die Oberfläche der Polyimidschicht 6 übersteht.

Gemäß einem ersten Ausführungsbeispiel wird das Amalgam 7 aus flüssigem Ga und 30 Gew. % Cu-Pulver mit Pulverteilchengrößen von 1 - 2 µm gebildet und bei einer Temperatur von 120 °C ausgehärtet. Gemäß einem zweiten Ausführungsbeispiel wird das Amalgam 7 aus flüssigem Ga und 30 - 45 Gew. % Ni-Pulver mit Pulverteilchengroßen von 1 - 2 µm gebildet und bei einer Temperatur von 120 °C ausgehärtet.

Gemäß einem weiteren Ausführungsbeispiel wird die flüssige Metallkomponente und die feste Metallkomponente des Amalgams 7 erst in der Vertiefung 2 miteinander vermischt. Dazu wird auf die Oberfläche der Vertiefung 2, d. h. auf die Hilfsschicht 5 beziehungsweise die Isolation 4 eine dünne Schicht aus der festen Metallkomponente aufgebracht. Als feste Metallkomponente wird dabei z. B. Antimon (Sb), Chrom (Cr) oder Silizium (Si) verwendet. Anschließend wird die Vertiefung 2 mit flüssigem Gallium aufgefüllt. Die Abscheidung der Schicht aus der festen Komponente erfolgt z. B. durch CVD oder naßchemisch. In der Vertiefung 2 löst sich nun die feste Komponente in der flüssigen Komponente, wobei es zu einer Durchmischung der festen Komponente mit der flüssigen Komponente und schließlich zur Aushärtung des Amalgams kommt. Dieses Ausführungsbeispiel hat den Vorteil, daß das Aushärten des Amalgams 7 erst in der Vertiefung 2 erfolgt, so daß die Verarbeitung der flüssigen Metallkomponente beliebig lange dauern kann.

Das Auffüllen der Vertiefung 2 kann durch Druck unterstützt werden. Dabei wird das flüssige Amalgam bzw. die flüssige Komponente unter Vakuum ganzflächig aufgegossen. Mit Luft oder Schutzgas unter Atmosphärendruck oder Überdruck wird das Amalgam bzw. die flüssige Komponente anschließend in die Vertiefung 2 gepreßt.

Die Schaltungsstrukturen in einem Substrat sind in der Regel hauptsächlich im Bereich der einen Fläche angeordnet. Sollen Vertiefungen in die den Schaltungsstrukturen abgewandte Fläche des Substrats erzeugt werden, so liegt es im Rahmen der Erfindung, zunächst auf die Fläche, in deren Bereich Schaltungsstrukturen hauptsächlich angeordnet sind, auf einen Träger aufzukleben. Als Träger eignet sich z. B. ein unbehandelter Si-Wafer, als Kleber wird z. B. Polyimid verwendet. Anschließend wird die dem Träger abgewandte Seite der Substratscheibe dünn geschliffen. Das Dünnschleifen erfolgt vorzugsweise durch mechanisches Rückseitenschleifen. Dann werden in der dem Träger abgewandten Fläche Vertiefungen hergestellt, wie dies anhand von Fig. 1 beschrieben wurde.

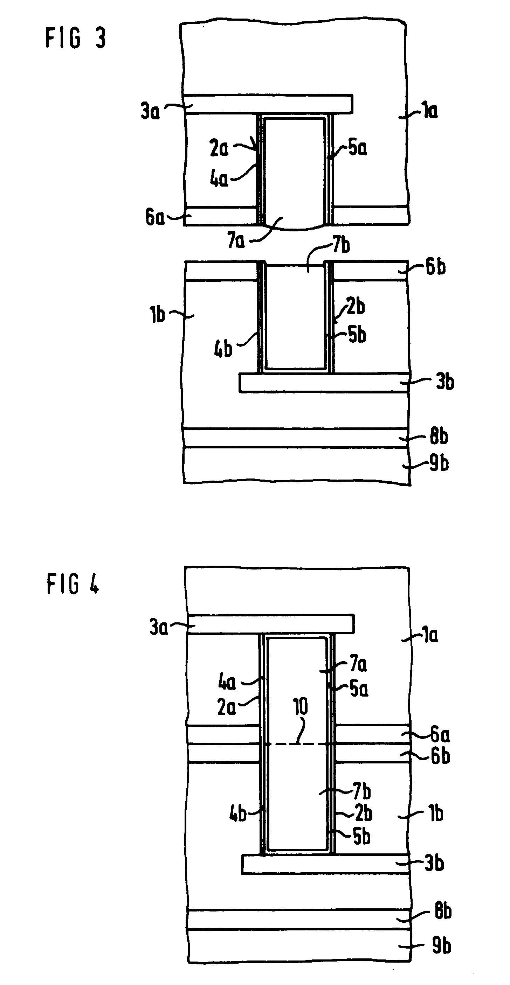

Zur Herstellung einer dreidimensionalen Schaltungsanordnung werden je zwei Substrate 1a und 1b übereinander angeordnet (s. Fig. 3). Das obere Substrat 1a weist eine Vertiefung 2a auf, die auf eine Metallisierungsebene 3a reicht, deren Seitenwände mit einer Isolation 4a versehen sind, die mit einer die Benetzung erleichternden Hilfsschicht 5a versehen ist und die mit ausgehärtetem Amalgam 7a gefüllt ist. An der Oberfläche ist das Substrat mit einer Polyimidschicht 6a versehen.

Das untere Substrat 1b ist an seiner Oberfläche mit einer Polyimidschicht 6b versehen und weist eine Vertiefung 2b auf, die auf eine Metallisierungsebene 3b reicht. Die Vertiefung 2b ist an den Seitenwänden mit einer Isolation 4b versehen. Sie ist ferner mit einer Hilfsschicht 5b versehen, die die Seitenwände und den Boden bedeckt und die elektrisch leitend ist und die die Benetzung mit Amalgam erleichtert. Das untere Substrat 1b ist an der der Vertiefung 2b abgewandten Seite über eine Klebeschicht 8b mit einem Träger 9b verbunden. Das Substrat 1b ist z. B. vor dem Aufbringen des Trägers 9b und der Klebeschicht 8b an der der Vertiefung 2b abgewandten Oberfläche dünn geschliffen worden.

Das untere Substrat 1b wird so angeordnet, daß der Träger 9b nach unten weist, während die Vertiefung 2b nach oben weist. Die Vertiefung 2b wird mit einem Amalgam 7b aufgefüllt, das dieselbe Zusammensetzung wie das Amalgam 7a aufweist. Das Amalgam 7b wird so dünnflüssig hergestellt, daß es in die Vertiefung 2b aufgegossen werden kann. Dabei muß beachtet werden, daß sich an der Oberfläche der Polyimidschicht 6b kein Amalgam befindet. Wahlweise kann das Amalgam 7b durch Abscheidung einer Schicht aus der festen Komponente an den Wänden der Vertiefung und Auffüllen mit der flüssigen Komponente hergestellt werden. Das obere Substrat 1a wird so oberhalb des unteren Substrats 1b angeordnet, daß die mit Amalgam 7a gefüllte Vertiefung 2a auf die mit Amalgam 7b gefüllte Vertiefung 2b trifft. Durch die Oberflächenspannung des flüssigen Amalgams 7b erfolgt dabei eine Feinjustierung der beiden Substrate 1a, 1b zueinander.

Das obere Substrat 1a und das untere Substrat 1b werden so zusammengefügt, daß sich die Polyimidschichten 6a, 6b berühren (s. Fig. 4). Das Amalgam 7a und das Amalgam 7b kommen dabei ebenfalls zur Berührung. Dabei wird das schon ausgehärtete Amalgam 7a an der Oberfläche in dem flüssigen Amalgam 7b angelöst. Dadurch kommt es zu einer Verbindung zwischen dem Amalgam 7a und dem Amalgam 7b. Diese Verbindung ist in Fig. 4 durch die gestrichelte Linie 10 angedeutet. Das noch flüssige Amalgam wird ausgehärtet, wobei eine feste Verbindung zwischen dem oberen Substrat 1a und dem unteren Substrat 1b entsteht. Die feste Verbindung bestehend aus dem Amalgam 7a und 7b stellt gleichzeitig einen Kontakt zwischen den Metallisierungsebenen 3a und 3b dar.

Bei Verwendung eines Amalgams, das beim Aushärten stark quillt, kann die Vertiefung 2a im oberen Substrat 1a im Bereich der Polyimidschicht 6a erweitert werden. Dies erfolgt z. B. durch eine Nut, die den Querschnitt der Vertiefung 2a im Bereich der Polyimidschicht 6a ringförmig umgibt und damit gegenüber dem Querschnitt im Bereich des oberen Substrats la erweitert. Durch diese Querschnittserweiterung der Vertiefung 2a im oberen Substrat 1a in dem Bereich, in dem sich die Polyimidschichten 6a, 6b berühren, stellt sicher, daß beim Aushärten des flüssigen Amalgams das Amalgam im Bereich der festen Verbindung verbleibt. Auf diese Weise wird ein Auseinanderlaufen des Amalgams an der Grenzfläche zwischen den beiden Polyimidschichten 6a, 6b, das zu einem Kurzschluß führen könnte, vermieden.

Durch Erwärmung der Anordnung auf 300 °C verschmelzen die Polyimidschichten 6a und 6b und bilden eine zusätzliche mechanische Verbindung.

Falls die fest miteinander verbundenen oberen und unteren Substrate la und 1b auf ein weiteres Substrat aufgebracht werden sollen, ist es zweckmäßig, vor dem Aufbringen des Trägers 9b auf dem unteren Substrat 1b nach dem Dünnschleifen in der dem oberen Substrat 1a abgewandten Seite Vertiefungen herzustellen, die mit einer Isolation, mit einer Hilfsschicht und mit ausgehärtetem Amalgam versehen werden. Nach der Verbindung von dem oberen Substrat 1a und dem unteren Substrat 1b können dann der Träger 9b und die Klebeschicht 8b entfernt werden und die Einheit aus oberem und unterem Substrat 1a, 1b als ganzes nach dem beschriebenen Verfahren auf einem weiteren Substrat angeordnet werden, mit dem eine feste Verbindung über Amalgamkontakte hergestellt wird.

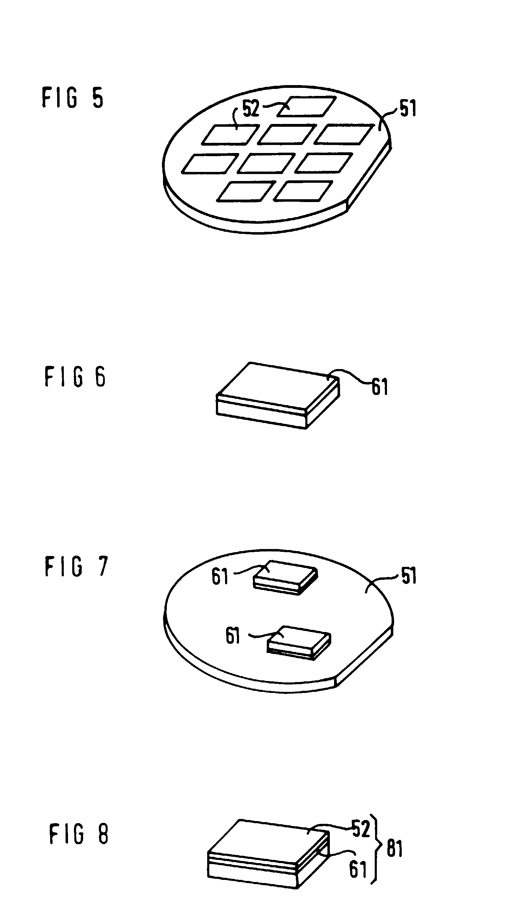

Um die Ausbeute bei der Herstellung einer dreidimensionalen Schaltungsanordnung zu erhöhen, ist es vorteilhaft, als unteres Substrat eine Substratscheibe zu verwenden, die eine Vielzahl von Bauelementen, d. h. insbesondere mikroelektronischen Schaltungen oder optoelektronischen Komponenten oder Sensorkomponenten, umfaßt, wie sie in Fig. 5 dargestellt ist. Als oberes Substrat werden vereinzelte Bauelemente 61 verwendet; ein solches Bauelement 61 ist beispielhaft in Fig. 6 dargestellt.

Auf ausgewählten Bauelementen 52 der Substratscheibe 51 werden vereinzelte Bauelemente 61 stückweise angeordnet. Die Bauelemente 52, auf denen vereinzelte Bauelemente 61 angeordnet werden, werden z. B. entsprechend ihrer elektrischen Charakteristiken ausgewählt. In Fig. 7 ist die Substratscheibe 51 mit darauf angeordneten vereinzelten Bauelementen 61 dargestellt. Die vereinzelten Bauelemente 61 sind jeweils an ihrer Unterseite, mit der sie auf die Oberseite der Substratscheibe 51 treffen, mit Vertiefungen versehen, die entsprechend dem anhand von Fig. 1 und 2 dargestellten Verfahren hergestellt und mit Amalgam gefüllt werden. Die Oberseite der Substratscheibe 51 ist (entsprechend dem unteren Substrat 1b in Fig. 3 und 4) mit Vertiefungen versehen worden, die mit flüssigem Amalgam gefüllt sind. Durch Aushärten des Amalgams werden die vereinzelten Bauelemente 61 fest mit der Substratscheibe 51 verbunden.

Die Substratscheibe 51 wird zerteilt, wobei vereinzelte Bauelementestapel 81, von denen einer beispielhaft in Fig. 8 dargestellt ist, entstehen. Die vereinzelten Bauelementstapel 81 umfassen dabei ein Bauelement 52 und ein vereinzeltes Bauelement 61 (s. Fig. 6 und Fig. 5). Das Bauelement 52 ist dabei über mindestens einen Amalgamkontakt fest mit dem vereinzelten Bauelement 61 verbunden. Von der Oberfläche des Bauelementes 52 werden dann Träger und Klebeschicht (entsprechend dem Beispiel aus Fig. 3 und 4) entfernt. Der Bauelementestapel 81 umfaßt zwei Ebenen. Zur Herstellung einer dreidimensionalen Schaltungsstruktur mit mehr als zwei Ebenen wird der Bauelementestapel 81 auf einer weiteren Substratscheibe angeordnet und mit dieser verbunden. Die weitere Substratscheibe ist entsprechend der Substratscheibe 51 präpariert. Der Bauelementestapel 81 wird so auf der weiteren Substratscheibe angeordnet, daß das Bauelement 52 nach unten weist. Auf diese Weise wird die dreidimensionale Schaltungsstruktur durch mehrfaches Anwenden des erfindungsgemäßen Verfahrens fertiggestellt.

Da die Vertiefungen in diesem Ausführungsbeispiel jeweils an der ganzen Substratscheibe gebildet werden und die Vereinzelung erst danach erfolgt, ist das Verfahren wirtschaftlich durchführbar.

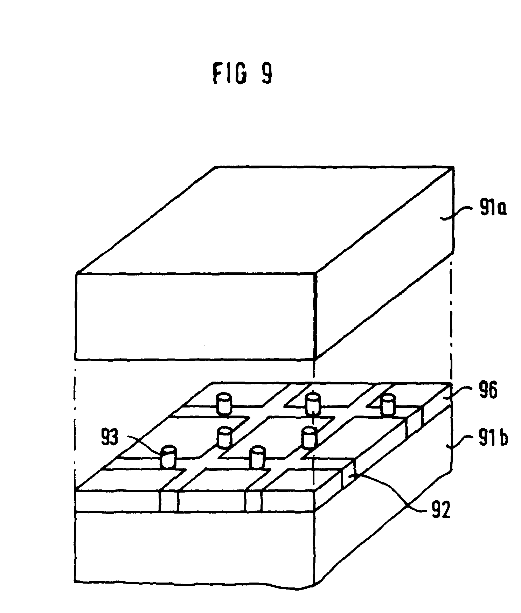

Für Schaltungsanordnungen, bei denen eine gute Wärmeableitung gewährleistet sein soll, werden zwischen einem oberen Substrat 91a und einem unteren Substrat 91b mit Amalgam gefüllte Metallbahnen 92 vorgesehen. Dazu wird in einer Polyimidschicht 96, die zwischen dem oberen Substrat 91a und dem unteren Substrat 91b angeordnet ist, Gräben hergestellt, die mit Amalgam aufgefüllt werden. Zusätzlich können in der Unterseite des oberen Substrats 91a und der Oberseite des unteren Substrats 91b zusätzliche Vertiefungen hergestellt werden, die auf die Gräben treffen und die mit Amalgan gefüllt werden. Daduch werden nach dem Aushärten des Amalgans mit den Metallbahnen 92 in Verbindung stehende Kühl finger 93 hergestellt (s. Fig. 9).

## Patentansprüche

1. Verfahren zur Herstellung einer dreidimensionalen Schaltungsanordnung,
- bei dem mindestens zwei Schaltungsstrukturen umfassende Substrate (1a, 1b) als Stapel übereinander angeordnet werden, wobei je zwei benachbarte Substrate ein oberes Substrat (1a) und ein unteres Substrat (1b) darstellen,
- bei dem in oberen Substraten (1a), die jeweils mit ihrer Unterseite unmittelbar auf der Oberseite eines unteren Substrates (1b) angeordnet sind, jeweils an der Unterseite des oberen Substrats (1a) mindestens eine Vertiefung (2a) erzeugt wird, die im jeweiligen Substrat (1a) bis auf eine Metallisierungsebene (3a) reicht und deren Seitenwände mit einer Isolation (4a) versehen werden,
- bei dem in den unteren Substraten (1b) jeweils an der Oberseite des Substrats (1b) mindestens eine Vertiefung (2b) erzeugt wird, die im jeweiligen Substrat (1b) bis auf eine Metallisierungsebene (3b) reicht, deren Seitenwände mit einer Isolation (4b) versehen werden und die so angeordnet werden, daß sie im Stapel auf eine zugeordnete Vertiefung (2a) des oberen Substrats (1a) treffen,
- bei dem die Vertiefungen (2a, 2b) jeweils mit einem Gemisch aus zwei Metallkomponenten, von denen die eine flüssig und die andere fest ist und von denen sich die feste Komponente in der flüssigen Komponente löst, was zur Aushärtung des Gemisches führt, gefüllt werden, das ausgehärtet wird, wobei eine feste Verbindung zwischen benachbarten Substraten (1a, 1b) entsteht.

2. Verfahren nach Anspruch 1,
- bei dem auf die Oberseite einer Substratscheibe, die eine Vielzahl von Bauelementen umfaßt, ein Träger aufgeklebt wird,
- bei dem die Substratscheibe an der dem Träger abgewandten Fläche dünn geschliffen wird,
- bei dem in der dem Träger abgewandten Fläche der Substratscheibe Vertiefungen erzeugt werden, die bis auf eine Metallisierungsebene reichen und deren Seitenwände mit einer Isolation versehen werden,
- bei dem die Substratscheibe so angeordnet wird, daß der Träger nach unten weist,
- bei dem die Vertiefungen in der Substratscheibe mit einem Gemisch aus zwei Metallkomponenten, von denen die eine flüssig und die andere fest ist und von denen sich die feste Komponente in der flüssigen Komponente löst, was zur Aushärtung des Gemisches führt, gefüllt werden,
- bei dem auf die dem Träger abgewandte Fläche der Substratscheibe, die als unteres Substrat verwendet wird, als oberes Substrat mindestens ein vereinzeltes Bauelement angeordnet wird, wobei das vereinzelte Bauelement in der auf die Oberseite der Substratscheibe treffenden Fläche mindestens eine Vertiefung aufweist, die auf eine Metallisierungsebene reicht, deren Seitenwand mit einer Isolation versehen ist, die mit ausgehärtetem Gemisch aus zwei Metallkomponenten, von denen die eine flüssig und die andere fest ist und von denen sich die feste Komponente in der flüssigen löst, was zur Aushärtung des Gemisches führt, gefüllt ist und die auf eine Vertiefung in der Oberseite der Substratscheibe trifft,
- bei dem das noch nicht ausgehärtete Gemisch aus den zwei Metallkomponenten ausgehärtet wird, wobei eine feste Verbindung zwischen dem Bauelement und der Substratscheibe entsteht,
- bei dem nach Zerteilen der Substratscheibe zur Vereinzelung von Bauelementstapeln, die jeweils ein vereinzeltes Bauelement und ein zugeordnetes Bauelement aus der Substratscheibe umfassen, der Träger abgelöst wird.

3. Verfahren nach Anspruch 2,
- bei dem in der Oberfläche der Substratscheibe vor dem Aufkleben des Trägers je Bauelement mindestens eine Vertiefung erzeugt wird, die auf eine Metallisierungsebene reicht, deren Seitenwände mit einer Isolation versehen werden und die mit einem Gemisch aus zwei Metallkomponenten, von denen die eine flüssig und die andere fest ist und von denen sich die feste Komponente in der flüssigen löst, was zur Aushärtung des Gemisches führt, gefüllt wird, das ausgehärtet wird,
- bei dem die nach dem Zerteilen der Substratscheibe und dem Entfernen des Trägers verbleibenden Bauelementstapel als obere Substrate auf einer anderen, entsprechend vorbereiteten Substratscheibe als unterem Substrat angeordnet werden, wobei die mit ausgehärtetem Gemisch aus zwei Metallkomponenten gefüllten Vertiefungen in der Oberfläche des Bauelementestapels auf zugeordnete, mit nicht ausgehärtetem Gemisch aus zwei Metallkomponenten, von denen die eine flüssig und die andere fest ist und von denen sich die feste Komponente in der flüssigen löst, was zur Aushärtung des Gemisches führt, gefüllte Vertiefungen an der Oberseite der weiteren Substratscheibe treffen,
- bei dem durch Aushärten des Gemisches aus zwei Metallkomponenten die Bauelementestapel mit der anderen Substratscheibe fest verbunden werden und die andere Substratscheibe zur Vereinzelung von um eine Ebene erhöhten Bauelementestapeln zerteilt.

4. Verfahren nach Anspruch 2 oder 3,
- bei dem die vereinzelten Bauelemente vor ihrer Vereinzelung dadurch mit einer mit ausgehärtetem Gemisch aus zwei Metallkomponenten gefüllten Vertiefung versehen werden, das in der Oberfläche einer weiteren Substratscheibe, die die Bauelemente vor der Vereinzelung umfaßt, je Bauelement mindestens eine Vertiefung erzeugt wird, die auf eine Metallisierungsebene reicht, deren Seitenwände mit einer Isolation versehen wird und die mit einem Gemisch aus zwei Metallkomponenten, von denen die eine flüssig und die andere fest ist und von denen sich die feste Komponente in der flüssigen Komponente löst, was zur Aushärtung des Gemisches führt, gefüllt wird,
- bei dem nach dem Aushärten des Gemisches aus zwei Metallkomponenten die Bauelemente vereinzelt werden.

5. Verfahren nach einem der Ansprüche 1 bis 4,
- bei dem zur Erzeugung der Vertiefungen an der Oberfläche des jeweiligen Substrats eine Fotolackmaske erzeugt wird,
- bei dem die Vertiefungen durch anisotropes Ätzen gebildet werden.

6. Verfahren nach einem der Ansprüche 1 bis 5,
bei dem die Vertiefungen mit einem Gemisch aus zwei Metallkomponenten, von denen die eine flüssig und die andere fest ist und von denen sich die feste Komponente in der flüssigen lost, was zur Aushärtung des Gemisches führt, gefüllt werden, das bei einer Temperatur entsprechend der Betriebstemperatur der Schaltungsanordnung ausgehärtet wird und das eine Schmelztemperatur oberhalb der Betriebstemperatur aufweist.

7. Verfahren nach Anspruch 6,
bei dem das Gemisch aus zwei Metallkomponenten mindestens flüssiges Ga und Cu-Pulver oder flüssiges Ga und Ni-Pulver enthält.

8. Verfahren nach einem der Ansprüche 1 bis 7,
bei dem die Substrate mikroelektronische Schaltungen und/oder optoelektronische Bauelemente umfassende Halbleitersubstrate sind.

9. Verfahren nach einem der Ansprüche 1 bis 8,
bei dem in der Oberseite der unteren Substrate und in der Unterseite der oberen Substrate zusätzliche Vertiefungen erzeugt werden, die in das Halbleitermaterial hineinreichen, deren Seitenwände mit einer Isolation versehen werden und die mit dem Gemisch aus zwei Metallkomponenten aufgefüllt werden.

10. Verfahren nach einem der Ansprüche 1 bis 9,
bei dem die Isolation an den Seitenwänden der Vertiefungen durch ganzflächiges Abscheiden einer konformen SiO₂-Schicht und anisotropes Rückätzen der SiO₂-Schicht gebildet wird.

11. Verfahren nach einem der Ansprüche 1 bis 10,
bei dem auf die Oberseite der unteren Substrate und auf die Unterseite der oberen Substrate vor dem Erzeugen der Vertiefungen jeweils ganzflächig eine Polyimidschicht aufgebracht wird.

12. Verfahren nach Anspruch 11,
bei dem in mindestens einer der Polyimidschichten Gräben erzeugt werden, die mit dem Gemisch aus zwei Metallkomponenten aufgefüllt werden.

13. Verfahren nach Anspruch 11 oder 12,
bei dem der Querschnitt der Vertiefungen in der Unterseite der oberen Substrate im Bereich der Polyimidschicht vergrößert wird.

14. Verfahren nach einem der Ansprüche 1 bis 13,
bei dem am Boden der Vertiefungen und auf der die Seitenwand der Vertiefungen bedeckenden Isolation eine Hilfsschicht abgeschieden wird, die die Benetzung mit dem Gemisch aus zwei Metallkomponenten fördert.

15. Verfahren nach Anspruch 14,
bei dem die Hilfsschicht aus Titan gebildet wird.

16. Verfahren nach einem der Ansprüche 1 bis 15,
bei dem das Gemisch aus zwei Metallkomponenten in flüssigem Zustand in die Vertiefungen eingefüllt wird und bei dem überschüssiges flüssiges Material abgeschüttelt wird.

17. Verfahren nach Anspruch 16,
bei dem das überschüssige flüssige Material durch eine taumelnde Bewegung oder durch Einbringen des Substrats in ein magnetisches Wechselfeld abgeschüttelt wird.

18. Verfahren nach einem der Ansprüche 1 bis 17,
bei dem zur Bildung des Gemisches aus zwei Metallkomponenten eine flüssige Komponente und eine pulverförmige Komponente gemischt werden, wobei die Pulverteilchen der pulverförmigen Komponente mit einer porösen Schicht aus Oxid, Nitrid oder Carbid versehen sind.

19. Verfahren nach einem der Ansprüche 1 bis 18,
bei dem zur Bildung des Gemisches aus zwei Metallkomponenten eine flüssige Komponente und eine pulverförmige Komponente gemischt werden, wobei die flüssige Komponente zur Erhöhung der Plastizität des ausgehärteten Gemisches dotiert wird.

20. Verfahren nach Anspruch 19,
bei dem als flüssige Komponente Gallium und als Dotierstoff Bor oder Wolfram verwendet wird.

21. Verfahren nach einem der Ansprüche 1 bis 17,
bei dem zur Bildung des Gemischs aus zwei Komponenten die feste Komponente als Schicht auf die Oberfläche der Vertiefung aufgebracht wird und die Vertiefung anschließend mit der flüssigen Komponente aufgefüllt wird, so daß die Lösung der festen Komponente und damit das Aushärten des Gemischs erst in der Vertiefung einsetzt.

22. Verfahren nach Anspruch 21,
bei dem als flüssige Komponente Gallium und als feste Komponente Antimon, Chrom oder Silizium verwendet werden.

## Claims

1. Process for the production of a three-dimensional circuit arrangement,
- in which at least two substrates (1a, 1b) that comprise circuit structures are arranged above one another as a stack, each pair of neighbouring substrates representing an upper substrate (1a) and a lower substrate (1b),
- in which, in upper substrates (1a) which are each arranged with their lower side directly on the upper side of a lower substrate (1b), at least one indentation (2a) which extends in the respective substrate (1a) as far as a metallization plane (3a) and whose side walls are provided with an insulation (4a), is respectively produced on the lower side of the upper substrate (1a),
- in which, in the lower substrates (1b), at least one indentation (2b) is respectively produced on the upper side of the substrate (1b), this indentation extending in the respective substrate (1b) as far as a metallization plane (3b), having its side walls provided with an insulation (4b) and being arranged in such a way that, in the stack, they coincide with a corresponding indentation (2a) in the upper substrate (1a),
- in which the indentations (2a, 2b) are each filled with a mixture of two metal components, one of which is liquid and the other of which is solid, and of which the solid component dissolves in the liquid component, which causes the mixture to set, and this mixture is set producing a solid connection between adjacent substrates (1a, 1b).

2. Process according to Claim 1,
- in which a support is bonded to the upper side of a substrate wafer which comprises a multiplicity of components,
- in which the substrate wafer is finely polished on the surface remote from the support,
- in which indentations, which extend as far as a metallization plane and whose side walls are provided with an insulation, are produced in the substrate wafer surface remote from the support,
- in which the substrate wafer is arranged in such a way that the support points downwards,
- in which the indentations in the substrate wafer are filled with a mixture of two metal components, one of which is liquid and the other of which is solid, and of which the solid component dissolves in the liquid component, which causes the mixture to set,
- in which at least one isolated component is arranged as an upper substrate on that surface of the substrate wafer used as a lower substrate which is remote from the support, the isolated component having at least one indentation in the surface coinciding with the upper side of the substrate wafer, this indentation extending as far as a metallization plane, having its side wall provided with an insulation, being filled with a set mixture of two metal components, one of which is liquid and the other of which is solid, and of which the solid component dissolves in the liquid component, which causes the mixture to set, and coinciding with an indentation in the upper side of the substrate wafer,
- in which the as yet unset mixture of the two metal components is set, producing a solid connection between the component and the substrate wafer,
- in which, after the substrate wafer has been divided upto isolate component stacks, each of which comprises an isolated component and a corresponding component from the substrate wafer, the support is removed.

3. Process according to Claim 2,
- in which at least one indentation per component is produced in the surface of the substrate wafer before the support is bonded on, this indentation extending as far as a metallization plane, having its side walls provided with an insulation, being filled with a mixture of two metal components, one of which is liquid and the other of which is solid, and of which the solid component dissolves in the liquid component, which causes the mixture to set, which is set,
- in which the component stacks remaining after the substrate wafer has been divided up and the support has been removed are arranged as upper substrates on another correspondingly prepared substrate wafer as the lower substrate, the indentations in the surface of the component stack which are filled with a set mixture of two metal components coinciding with corresponding indentations on the upper side of the further substrate wafer which are filled with an unset mixture of two metal components, one of which is liquid and the other of which is solid, and of which the solid component dissolves in the liquid component, which causes the mixture to set,
- in which, by the mixture of two metal components setting, the component stacks are firmly connected to the other substrate wafer, and the other substrate wafer is divided up to isolate component stacks increased by one plane.

4. Process according to Claim 2 or 3,
- in which, before they are isolated, the isolated components are provided with an indentation filled with a set mixture of two metal components in such a way that in the surface of a further substrate wafer which comprises the components before isolation, at least one indentation is produced per component, this indentation extending as far as a metallization plane, having its side walls provided with an insulation and being filled with a mixture of two metal components, one of which is liquid and the other of which is solid, and of which the solid component dissolves in the liquid component, which causes the mixture to set,
- in which the components are isolated after the mixture of two metal components has set.

5. Process according to one of Claims 1 to 4,
- in which a photoresist mask is produced on the surface of the respective substrate in order to produce the indentations,
- in which the indentations are formed by anisotropic etching.

6. Process according to one of Claims 1 to 5, in which the indentations are filled with a mixture of two metal components, one of which is liquid and the other of which is solid, and of which the solid component dissolves in the liquid component, which causes the mixture to set, which is set at a temperature corresponding to the operating temperature of the circuit arrangement and which has a melting temperature higher than the operating temperature.

7. Process according to Claim 6, in which the mixture of two metal components contains at least liquid Ga and Cu powder or liquid Ga and Ni powder.

8. Process according to one of Claims 1 to 7, in which the substrates are semiconductor substrates comprising microelectronic circuits and/or optoelectronic components.

9. Process according to one of Claims 1 to 8, in which additional indentations are produced in the upper side of the lower substrates and in the lower side of the upper substrates, these indentations extending into the semiconductor material, having their side walls provided with an insulation and being filled with the mixture of two metal components.

10. Process according to one of Claims 1 to 9, in which the insulation on the side walls of the indentations is formed by depositing a conformal SiO₂ layer surface-wide, and etching back the SiO₂ layer anisotropically.

11. Process according to one of Claims 1 to 10, in which a polyimide layer is in each case applied surface-wide to the upper side of the lower substrates and to the lower side of the upper substrates before the indentations are produced.

12. Process according to Claim 11, in which trenches that are filled with the mixture of two metal components are produced in at least one of the polyimide layers.

13. Process according to Claim 11 or 12, in which the cross-section of the indentations in the lower side of the upper substrates is enlarged in the region of the polyimide layer.

14. Process according to one of Claims 1 to 13, in which an auxiliary layer, which promotes wetting with the mixture of two metal components, is deposited on the bottom of the indentations and on the insulation covering the side wall of the indentations.

15. Process according to Claim 14, in which the auxiliary layer is formed from titanium.

16. Process according to one of Claims 1 to 15, in which the mixture of two metal components is introduced into the indentations in the liquid state, and in which excess liquid material is shaken off.

17. Process according to Claim 16, in which the excess liquid material is shaken off using a rolling movement or by introducting the substrate into an alternating magnetic field.

18. Process according to one of Claims 1 to 17, in which, in order to form the mixture of two metal components, a liquid component and a pulverulent component are mixed, the powder particles of the pulverulent component being provided with a porous layer of oxide, nitride or carbide.

19. Process according to one of Claims 1 to 18, in which, in order to form the mixture of two metal components, a liquid component and a pulverulent component are mixed, the liquid component being doped in order to increase the plasticity of the mixture when set.

20. Process according to Claim 19, in which gallium is used as the liquid component and boron or tungsten is used as the dopant.

21. Process according to one of Claims 1 to 17, in which, in order to form the mixture of two components, the solid component is applied as a layer to the surface of the indentation, and the indentation is subsequently filled with the liquid component, so that the dissolving of the solid component, and therefore the setting of the mixture, only takes place in the indentation.

22. Process according to Claim 21, in which gallium is used as the liquid component and antimony, chromium or silicon is used as the solid component.

## Revendications

1. Procédé de fabrication d'un circuit tridimensionnel,
- dans lequel on dispose au moins deux substrats (1a, 1b) comprenant des dispositifs à circuits, l'un au-dessus de l'autre, sous forme de pile, deux substrats contigus représentant à chaque fois un substrat supérieur (1a) et un substrat inférieur (1b),
- dans lequel on crée dans les substrats supérieurs (1a) dont la face inférieure est disposée directement sur la face supérieure d'un substrat inférieur (1b), à chaque fois à la face inférieure du substrat supérieur (1a), au moins un creux (2a) qui s'étend dans le substrat respectif (1a) jusqu'à un plan de métallisation (3a) et dont les parois latérales sont pourvues d'une isolation (4a),
- dans lequel on crée dans les substrats inférieurs (1b), à chaque fois à la face supérieure du substrat (1b), au moins un creux (2b) qui s'étend dans le substrat respectif (1b) jusqu'à un plan de métallisation (3b), dont les parois latérales sont pourvues d'une isolation (4b) et qui est disposé de manière à coïncider dans la pile avec un creux associé (2a) du substrat supérieur (1a),
- dans lequel on remplit les creux (2a, 2b) d'un mélange de deux constituants métalliques dont l'un est liquide et l'autre solide et dont le constituant solide se dissout dans le constituant liquide, ce qui conduit à la solidification du mélange, mélande qui est solidifié de manière à obtenir une liaison solide entre substrats contigus (1a, 1b).

2. Procédé selon la revendication 1,
- dans lequel on colle un support sur la face supérieure d'une plaquette de substrat contenant une multitude de composants,
- dans lequel on réduit par rectification l'épaisseur de la plaquette de substrat, au niveau de la surface opposée au support,
- dans lequel on crée dans la surface de la plaquette de substrat opposée au support des creux qui s'étendent jusqu'à un plan de métallisation et dont les parois latérales sont pourvues d'une isolation,
- dans lequel on dispose la plaquette de substrat de façon à ce que le support soit dirigé vers le bas,
- dans lequel on remplit les creux ménagés dans la plaquette de substrat d'un mélange de deux constituants métalliques dont l'un est liquide et l'autre solide et dont le constituant solide se dissout dans le constituant liquide, ce qui conduit à la solidification du mélange,
- dans lequel on dispose sur la surface de la plaquette de substrat opposée au support servant de substrat inférieur au moins un composant individuel servant de substrat supérieur, le composant individuel comportant dans la surface coïncidant avec la face supérieure de la plaquette de substrat au moins un creux qui s'étend jusqu'à un plan de métallisation, dont la paroi latérale est pourvue d'une isolation, qui est rempli d'un mélange solidifié de deux constituants métalliques dont l'un est liquide et l'autre solide et dont le constituant solide se dissout dans le constituant liquide, ce qui conduit à la solidification du mélange, et qui coïncide avec un creux ménagé dans la face supérieure de la plaquette de substrat,
- dans lequel le mélange non encore solidifié constitué des deux constituants métalliques se solidifie, ce qui permet d'obtenir une liaison solide entre le composant et la plaquette de substrat,
- dans lequel on détache le support après avoir divisé la plaquette de substrat pour obtenir des piles de composants individuelles comprenant chacune un composant individuel et un composant associé de la plaquette de substrat.

3. Procédé selon la revendication 2,
- dans lequel on crée dans la surface de la plaquette de substrat, avant de coller le support, par composant au moins un creux qui s'étend jusqu'à un plan de métallisation, dont les parois latérales sont pourvues d'une isolation et qui est rempli d'un mélange de deux constituants métalliques dont l'un est liquide et l'autre solide et dont le constituant solide se dissout dans le constituant liquide, ce qui conduit à la solidification du mélange, mélange qui est solidifié,
- dans lequel on dispose les piles de composants subsistant après la division de la plaquette de substrat et l'élimination du support, en tant que substrats supérieurs sur une autre plaquette de substrat préparée d'une manière correspondante et servant de substrat inférieur, les creux remplis du mélange solidifié de deux constituants métalliques dans la surface de la pile de composants coïncidant à la face supérieure de l'autre plaquette de substrat avec des creux correspondants remplis d'un mélange non solidifié de deux constituants métalliques, dont l'un est liquide et l'autre solide et dont le constituant solide se dissout dans le constituant liquide, ce qui conduit à la solidification du mélange,
- dans lequel on crée, par solidification du mélange de deux constituants métalliques, une liaison solide entre les piles de composants et l'autre plaquette de substrat, et on divise l'autre plaquette de substrat pour obtenir des piles de composants individuelles augmentées d'un plan.

4. Procédé selon la revendication 2 ou 3,
- dans lequel on munit les composants individuels, avant leur individualisation, d'un creux rempli d'un mélange solidifié de deux constituants métalliques, en créant dans la surface d'une autre plaquette de substrat contenant les composants avant l'individualisation, par composant au moins un creux qui s'étend jusqu'à un plan de métallisation, dont les parois latérales sont pourvues d'une isolation et qui est rempli d'un mélange de deux constituants métalliques dont l'un est liquide et l'autre solide et dont le constituant solide se dissout dans le constituant liquide, ce qui conduit à la solidification du mélange,
- dans lequel, après la solidification du mélange de deux constituants métalliques, on individualise les composants.

5. Procédé selon l'une des revendications 1 à 4,
- dans lequel, pour obtenir les creux à la surface du substrat respectif, on réalise un masque en laque photosensible,
- dans lequel on forme les creux par gravure anisotrope.

6. Procédé selon l'une des revendications 1 à 5, dans lequel on remplit les creux d'un mélange de deux constituants métalliques dont l'un est liquide et l'autre solide et dont le constituant solide se dissout dans le constituant liquide, ce qui conduit à la solidification du mélange, mélange qui est solidifié à une température adaptée à la température de service du circuit et dont la température de fusion est supérieure à la température de service.

7. Procédé selon la revendication 6, dans lequel le mélange de deux constituants métalliques contient au moins du Ga liquide et du Cu en poudre ou du Ga liquide et du Ni en poudre.

8. Procédé selon l'une des revendications 1 à 7, dans lequel les substrats sont des circuits micro-électroniques et/ou des substrats à semi-conducteurs comprenant des composants opto-électroniques.

9. Procédé selon l'une des revendications 1 à 8, dans lequel on crée dans la face supérieure des substrats inférieurs et dans la face inférieure des substrats supérieurs des creux supplémentaires qui s'avancent dans le matériau semi-conducteur, dont les parois latérales sont pourvues d'une isolation et qui sont remplis du mélange de deux constituants métalliques.

10. Procédé selon l'une des revendications 1 à 9, dans lequel l'isolation sur les parois latérales des creux est obtenue par dépôt d'une couche conforme en SiO₂ sur toute la surface et par gravure en retrait anisotrope de la couche en SiO₂.

11. Procédé selon l'une des revendications 1 à 10, dans lequel, avant de créer les creux, on dépose une couche de polyimide sur toute la surface de la face supérieure des substrats inférieurs et de la face inférieure des substrats supérieurs.

12. Procédé selon la revendication 11, dans lequel on crée dans au moins l'une des couches de polyimide des tranchées que l'on remplit du mélange de deux constituants métalliques.

13. Procédé selon la revendication 11 ou 12, dans lequel on agrandit la section des creux ménagés dans la face inférieure des substrats supérieurs au niveau de la couche de polyimide.

14. Procédé selon l'une des revendications 1 à 13, dans lequel on dépose au fond des creux et sur l'isolation couvrant la paroi latérale des creux une couche auxiliaire qui favorise le mouillage avec le mélange de deux constituants métalliques.

15. Procédé selon la revendication 14, dans lequel on réalise la couche auxiliaire en titane.

16. Procédé selon l'une des revendications 1 à 15, dans lequel on verse le mélange de deux constituants métalliques en état liquide dans les creux et dans lequel on élimine la matière liquide excédentaire par agitation.

17. Procédé selon la revendication 16, dans lequel on élimine la matière liquide excédentaire en effectuant un mouvement oscillant ou en introduisant le substrat dans un champ alternatif magnétique.

18. Procédé selon l'une des revendications 1 à 17, dans lequel, pour obtenir le mélange de deux constituants métalliques, on mélange un constituant liquide et un constituant en poudre, les particules de poudre du constituant en poudre étant couvertes d'une couche poreuse en oxyde, nitrure ou carbure.

19. Procédé selon l'une des revendications 1 à 18, dans lequel, pour obtenir le mélange de deux constituants métalliques, on mélange un constituant liquide et un constituant en poudre, le constituant liquide étant dopé pour augmenter la plasticité du mélange solidifié.

20. Procédé selon la revendication 19, dans lequel on utilise comme constituant liquide du gallium et comme dopant du bore ou du tungstène.

21. Procédé selon l'une des revendications 1 à 17, dans lequel, pour obtenir le mélange de deux constituants, on dépose le constituant solide sous forme de couche sur la surface du creux et on remplit ensuite le creux du constituant liquide, de sorte que la dissolution du constituant solide et donc la solidification du mélange débute seulement dans le creux.

22. Procédé selon la revendication 21, dans lequel on utilise comme constituant liquide du gallium et comme constituant solide de l'antimoine, du chrome ou du silicium.
